# EUROPEAN PATENT APPLICATION

(11) **EP 3 435 468 A1**
(43) Date of publication of application: **30.01.2019**
(21) Application number: 18185586.7
(22) Date of filing: 25.07.2018
(51) Int. Cl.: H01M 10/056, H01M 10/052

(54) **METHOD FOR PREPARING COMPOSITE SOLID STATE ELECTROLYTE**

(30) Priority: 25.07.2017 CN 201710613010
(71) Applicant: Optimumnano Energy Co., Ltd, Pingshan New District Shenzhen Guangdong 518118 (CN)
(72) Inventor: Yang, Xing, Shenzhen, Guangdong 518118 (CN); Liu, Xiao yan, Shenzhen, Guangdong 518118 (CN); Wang, Hai tao, Shenzhen, Guangdong 518118 (CN)
(74) Representative: Greaves Brewster LLP

(57) **Abstract**

A method for preparing a composite solid state electrolyte includes the steps of: 1): dissolving a polyethylene oxide monomer and an additive in an organic solvent, obtaining a polymer after filtering; 2): adding Ru(Cp*)Cl(PPh₃)₂ to an organic solvent, dissolving the polymer in step 1) and a polystyrene monomer in the organic solvent, and obtaining a PEO-PST two-phase polymer; 3): adding Li₂S, P₂S₅, GeS₂, Al₂S₃, BaS and milling, pressing the milled powder into a wafer, and obtaining an Al, Ba doped solid state electrolyte material LABGPS; and 4): mixing the PEO-PST two-phase polymer in step 2) and the solid state electrolyte material LABGPS in step 3), adding a lithium salt, dissolving and dispersing the mixture in a mixed solution of tetrahydrofuran and acetone to form a sol, drying the sol, transferring the dried sol to a vacuum oven for vacuum drying, and obtaining a final composite solid state electrolyte PEO-PST-LABGPS.

## Description

### BACKGROUND OF THE INVENTION

### Field of the Invention

The present invention generally relates to battery materials and, more particular, relates to a method for preparing a composite solid state electrolyte.

### Description of the Related Art

At present, the electrolytes used in lithium ion batteries are organic liquid electrolytes. When the lithium ion battery is abused, overheated, or internal short-circuited, it is easy to ignite the organic liquid, causing the lithium ion battery to ignite and/or explode. Solid electrolytes have widely used due to their advantages of high safety, wide working temperature range, wide electrochemical window, good cycle performance and prevention of puncture of lithium dendrites. Solid electrolytes are classified into organic solid electrolyte and inorganic solid state electrolyte.

As a kind of organic solid state electrolyte material, PEO (polyethylene oxide)-based polymer electrolyte has good flexibility and tensile shear property, and can be used to prepare a flexible bendable battery. However, PEO-based polymer electrolyte has a disadvantage of low ionic conductivity at room temperature, and therefore is difficult to meet the requirements of application of lithium ion battery at room temperature. Compared with the polymer solid state electrolyte, the inorganic solid state electrolyte can maintain high chemical stability over a wide range of temperature, has wide electrochemical window and higher mechanical strength. Among them, LGPS (inorganic ceramic electrolyte, Li₁₀GeP₂S₁₂) type inorganic solid state electrolyte has high conductivity at room temperature, and becomes one of the most promising electrolyte materials. However, the LGPS type inorganic solid state electrolyte has the disadvantages of large brittleness, poor flexibility, complicated preparation process, and high cost.

In view of the foregoing, what is needed, therefore, is to provide a method for preparing a composite solid state electrolyte which can solve the problems as discussed above.

### SUMMARY OF THE INVENTION

One object of the present invention is to provide a method for preparing a composite solid state electrolyte having a high ionic conductivity, wide electrochemical window, stable structure to metallic lithium, good mechanical processing property and good interface stability.

According to one embodiment of the present invention, a method for preparing a composite solid electrolyte is provided. The method includes the steps of:
step 1): dissolving a polyethylene oxide monomer and an additive in an organic solvent, stirring at a certain temperature, and obtaining a polymer after filtering;
step 2): adding Ru(Cp*)Cl(PPh₃)₂ to an organic solvent, dissolving the polymer obtained in step 1) and a polystyrene monomer in the organic solvent, stirring at a certain temperature, and obtaining a PEO-PST two-phase polymer after filtering and drying;
step 3): adding Li₂S, P₂S₅, GeS₂, Al₂S₃, BaS in a ball mill tank in a certain proportion and milling evenly to obtain a ball milled powder, pressing the ball milled powder into a wafer, and obtaining an Al, Ba doped solid state electrolyte material LABGPS by microwave heating the wafer; and
step 4): mixing the PEO-PST two-phase polymer obtained in step 2) and the solid state electrolyte material LABGPS obtained in step 3), adding a lithium salt and obtaining a mixture, dissolving and dispersing the mixture in a mixed solution of tetrahydrofuran and acetone, stirring to form a uniform sol and transferring the sol to a mold, drying the sol to remove the solvent, then transferring the dried sol to a vacuum oven for vacuum drying, and obtaining a final composite solid state electrolyte PEO-PST-LABGPS.

According to one aspect of the present invention, the additive in step 1) is a mixed solution of PhCOCHCl₂, RuCl₂(PPh₃)₃ and dibutylamine.

According to one aspect of the present invention, the stirring temperature in step 1) is 70-90 °C, and the stirring time is 2-3 hours.

According to one aspect of the present invention, the organic solvent in step 1), step 2) is at least one of toluene, xylene, cyclohexylbenzene, 1,2-diphenylethane, ethylbenzene, diethylbenzene, propyl benzene, 1,2,4-trimethylbenzene, butylbenzene, dodecylbenzene, p-methyl cumene, biphenyl and naphthalene.

According to one aspect of the present invention, in step 2), the stirring temperature is 90-120 °C, and the stirring time is 3-5 hours.

According to one aspect of the present invention, in step 3), a molar ratio of Ge, P, S in Li₂S, P₂S₅, GeS₂, Al₂S₃ and BaS is Ge:P:S = 1:2:12, and a molar ratio of Li, Al, Ba is Li:Al:Ba = 10-3x-2y:x:y, wherein 0.01≤x≤0.2, 0.05≤y≤0.3.

According to one aspect of the present invention, in step 3), the microwave heating temperature is 500-600 °C, and the heating time is 3-6 hours.

According to one aspect of the present invention, a mass content of the mixed PEO-PST two-phase polymer and the solid state electrolyte material LABGPS in step 4) is 30-35% and 65-70% respectively.

According to one aspect of the present invention, in step 4), the lithium salt is LiClO₄, and a molar ratio of a lithium element in the LiClO₄ to the ethylene oxide monomer in the PEO-PST two-phase polymer is 0.03 to 0.08.

According to one aspect of the present invention, in step 4), the temperature in the vacuum oven is 110-130 °C, and the vacuum drying time is 20-24 hours.

Compared with the prior art, according to the method for preparing the composite solid state electrolyte of the present invention, the composite solid state electrolyte prepared has the advantages of high ionic conductivity, wide electrochemical window, stable structure to metallic lithium, good mechanical processing property and good interface stability, and the all solid state lithium battery using the composite solid state electrolyte has excellent charge and discharge performance and cycle performance.

### BRIEF DESCRIPTION OF THE DRAWINGS

Implementations of the present technology will now be described, by way of example only, with reference to the attached drawings. It may be understood that these drawings are not necessarily drawn to scale, and in no way limit any changes in form and detail that may be made to the described embodiments by one skilled in the art without departing from the spirit and scope of the described embodiments.
FIG. 1 depicts charging and discharging curves of a Sample 1 battery according to Example 1 of the present invention at different temperatures;
FIG. 2 depicts charging and discharging curves of a Sample 2 battery according to Example 2 of the present invention at different temperatures;
FIG. 3 depicts charging and discharging curves of a Sample 3 battery according to Example 3 of the present invention at different temperatures;
FIG. 4 depicts charging and discharging curves of a Sample 4 battery according to Example 4 of the present invention at different temperatures; and
FIG. 5 depicts cycle curves of a Sample 1 battery according to Example 1 of the present invention at different temperatures.

### DETAILED DESCRIPTION OF THE PREFERRED EMBODIMENTS

In order to make the purposes, technical solutions, and advantages of the present invention be clearer, the present invention will be further described in detail hereafter with reference to the accompanying drawings and embodiments. However, it will be understood by those of ordinary skill in the art that the embodiments described herein can be practiced without these specific details. In other instances, methods, procedures and components have not been described in detail so as not to obscure the related relevant feature being described. Also, it should be understood that the embodiments described herein are only intended to illustrate but not to limit the present invention.

According to one embodiment of the present invention, a method for preparing a composite solid state electrolyte is provided. The method includes the steps of:
step 1): dissolving a polyethylene oxide monomer and an additive in an organic solvent, stirring at a certain temperature, and obtaining a polymer after filtering;
step 2): adding Ru(Cp*)Cl(PPh₃)₂ to an organic solvent, dissolving the polymer obtained in step 1) and a polystyrene monomer in the organic solvent, stirring at a certain temperature, and obtaining a PEO-PST two-phase polymer after filtering and drying;
step 3): adding Li₂S, P₂S₅, GeS₂, Al₂S₃, BaS in a ball mill tank in a certain proportion and milling evenly to obtain a ball milled powder, pressing the ball milled powder into a wafer, and obtaining an Al, Ba doped solid state electrolyte material LABGPS by microwave heating the wafer; and
step 4): mixing the PEO-PST two-phase polymer obtained in step 2) and the solid state electrolyte material LABGPS obtained in step 3), adding a lithium salt and obtaining a mixture, dissolving and dispersing the mixture in a mixed solution of tetrahydrofuran and acetone, stirring to form a uniform sol and transferring the sol to a mold, drying the sol to remove the solvent, then transferring to a vacuum oven for vacuum drying, and obtaining a final composite solid state electrolyte PEO-PST-LABGPS.

Specifically, the additive in step 1) is a mixed solution of PhCOCHCl₂, RuCl₂(PPh₃)₃ and dibutylamine. The stirring temperature in step 1) is 70-90 °C, and the stirring time is 2-3 hours. The organic solvent in step 1), step 2) is at least one of toluene, xylene, cyclohexylbenzene, 1,2-diphenylethane, ethylbenzene, diethylbenzene, propyl benzene, 1,2,4-trimethylbenzene, butylbenzene, dodecylbenzene, p-methyl cumene, biphenyl and naphthalene. In step 2), the stirring temperature is 90-120 °C, the stirring time is 3-5 hours.

Specifically, In step 3), a molar ratio of Ge, P, S in Li₂S, P₂S₅, GeS₂, Al₂S₃ and BaS is Ge:P:S = 1:2:12, and a molar ratio of Li, Al, Ba is Li:Al:Ba = 10-3x-2y:x:y, wherein 0.01<x<0.2, 0.05≤y≤0.3. In step 3), the microwave heating temperature is 500-600 °C, and the heating time is 3-6 hours. The mass content of the mixed PEO-PST two-phase polymer and the solid state electrolyte material LABGPS in step 4) is 30-35% and 65-70% respectively. In step 4), the lithium salt is LiClO₄, and a molar ratio of a lithium element in the LiClO₄ to the ethylene oxide monomer in the PEO-PST two-phase polymer is 0.03 to 0.08. In step 4), the temperature in the vacuum oven is 110-130 °C, and the vacuum drying time is 20-24 hours.

### Example 1

(1) Dissolving polyethylene oxide monomer and PhCOCHCl₂, RuCl₂(PPh₃)₃, dibutyl aminein in toluene solution to obtain a mixture, stirring the mixture at 80 °C for 2 h, and then filtering the mixture through a silica gel column to remove impurities and obtain the polymer (PEO);
(2) adding Ru(Cp*)Cl(PPh₃)₂ to the toluene solution, dissolving the polymer (PEO) obtained in step (1) and the polystyrene (PST) monomer in the toluene solution, stirring at 100 °C for 4 h, and obtaining the PEO-PST two-phase polymer after filtering and drying;
(3) adding Li₂S, P₂S₅, GeS₂, Al₂S₃, BaS in a zirconia ball mill tank in a certain proportion (wherein the molar ratio of three elements Ge:P:S is 1:2:12, the molar ratio of three elements Li:Al:Ba is 10-3x-2y:x:y, 0.01≤x≤0.2, 0.05≤y≤0.3) and milling evenly to obtain a ball milled powder, pressing the ball milled powder into a wafer, and obtaining the Al, Ba doped solid state electrolyte material LABGPS (Li_{10-3x-2y}AlₓBa_{y}GeP₂S₁₂, 0.01≤x≤0.2, 0.05≤y≤0.3) by microwave heating the wafer in a tube-type microwave oven at 550 °C for 4 h; and
(4) mixing the PEO-PST two-phase polymer (mass fraction of 30%) obtained in step (2) and the solid state electrolyte material LABGPS (mass fraction of 70%) obtained in step (3), adding LiClO₄ (the molar ratio of the lithium element in the LiClO₄ to the ethylene oxide monomer in the PEO-PST two-phase polymer is 0.03 to 0.08) to obtain a mixture, dissolving and dispersing the mixture in a mixed solution of tetrahydrofuran and acetone (the volume ratio of tetrahydrofuran to acetone is 1:1) to obtain a sol, stirring the sol for 4 h to form a uniform sol and then transferring the sol to a polytetrafluoroethylene mold, drying to remove the solvent, then transferring the dried sol to a vacuum oven, vacuum drying the dried sol at 120 °C for 24 h to obtain the final composite solid state electrolyte PEO-PST-LABGPS.

### Example 2

(1) Dissolving polyethylene oxide monomer and PhCOCHCl₂, RuCl₂(PPh₃)₃, dibutyl aminein in toluene solution to obtain a mixture, stirring the mixture at 80 °C for 2 h, and then filtering the mixture through a silica gel column to remove impurities and obtain the polymer (PEO);
(2) adding Li₂S, P₂S₅, GeS₂, Al₂S₃, BaS in a zirconia ball mill tank in a certain proportion (wherein the molar ratio of three elements of Ge:P:S is 1:2:12, the molar ratio of three elements of Li:Al:Ba is 10-3x-2y:x:y, 0.01≤x≤0.2, 0.05≤y≤0.3) and milling evenly to obtain a ball milled powder, pressing the ball milled powder into a wafer, and obtaining the Al, Ba doped solid state electrolyte material LABGPS (Li_{10-3x-2y}AlₓBa_{y}GeP₂S₁₂, 0.01≤x≤0.2, 0.05≤y≤0.3) by microwave heating the wafer in a tube-type microwave oven at 550 °C for 4 h; and
(3) mixing the polymer PEO (mass fraction of 30%) obtained in step (1) and the solid state electrolyte material LABGPS (mass fraction of 70%) obtained in step (2), adding LiClO₄ (the molar ratio of the lithium element in the LiClO₄ to the ethylene oxide monomer in the polymer PEO is 0.03 to 0.08) to obtain a mixture, dissolving and dispersing the mixture in a mixed solution of tetrahydrofuran and acetone (the volume ratio of tetrahydrofuran to acetone is 1:1) to obtain a sol, stirring the sol for 4 h to form a uniform sol and then transferring the sol to a polytetrafluoroethylene mold, drying to remove the solvent, then transferring the dried sol to a vacuum oven, vacuum drying the dried sol at 120 °C for 24 h to obtain the final solid state electrolyte PEO-LABGPS.

### Example 3

(1) Dissolving polyethylene oxide monomer and PhCOCHCl₂, RuCl₂(PPh₃)₃, dibutyl aminein in toluene solution to obtain a mixture, stirring the mixture at 80 °C for 2 h, and then filtering the mixture through a silica gel column to remove impurities and obtain the polymer (PEO);
(2) adding Ru(Cp*)Cl(PPh₃)₂ to the toluene solution, dissolving the polymer (PEO) obtained in step (1) and the polystyrene (PST) monomer in the toluene solution, stirring at 100 °C for 4 h, and obtaining the PEO-PST two-phase polymer afterfiltering and drying;
(3) adding Li₂S, P₂S₅, GeS₂ in a zirconia ball mill tank at a molar ratio of 5:1:1 and milling evenly to obtain a ball milled powder, pressing the ball milled powder into a wafer, and obtaining the solid state electrolyte material Li₁₀GeP₂S₁₂ by microwave heating the wafer in a tube-type microwave oven at 550 °C for 4 h; and
(4) mixing the PEO-PST two-phase polymer (mass fraction of 30%) obtained in step (2) and the solid state electrolyte material Li₁₀GeP₂S₁₂ (mass fraction of 70%) obtained in step (3), adding LiClO₄ (the molar ratio of the lithium element in the LiClO₄ to the ethylene oxide monomer in the PEO-PST two-phase polymer is 0.03 to 0.08) to obtain a mixture, dissolving and dispersing the mixture in a mixed solution of tetrahydrofuran and acetone (the volume ratio of tetrahydrofuran to acetone is 1:1) to obtain a sol, stirring the sol for 4 h to form a uniform sol and then transferring the sol to a polytetrafluoroethylene mold, drying to remove the solvent, then transferring the dried sol to a vacuum oven, vacuum drying the dried sol at 120 °C for 24 h to obtain the final solid state electrolyte PEO-PST-LGPS.

### Example 4

(1) Dissolving polyethylene oxide monomer and PhCOCHCl₂, RuCl₂(PPh₃)₃, dibutyl aminein in toluene solution to obtain a mixture, stirring the mixture at 80 °C for 2 h, and then filtering the mixture through a silica gel column to remove impurities to obtain the polymer (PEO);
(2) adding Li₂S, P₂S₅, GeS₂ in a zirconia ball mill tank at a molar ratio of 5:1:1 and milling evenly to obtain a ball milled powder, pressing the ball milled powder into a wafer, and obtaining the solid state electrolyte material Li₁₀GeP₂S₁₂ by microwave heating the wafer in a tube-type microwave oven at 550 °C for 4 h;
(3) mixing the polymer PEO (mass fraction of 30%) obtained in step (1) and the solid state electrolyte material Li₁₀GeP₂S₁₂ (mass fraction of 70%) obtained in step (2), adding LiClO₄ (the molar ratio of the lithium element in the LiClO₄ to the ethylene oxide monomer in the polymer PEO is 0.03 to 0.08) to obtain a mixture, dissolving and dispersing the mixture in the mixed solution of tetrahydrofuran and acetone (the volume ratio of tetrahydrofuran to acetone is 1:1) to obtain a sol, stirring the sol for 4 h to form a uniform sol and then transferring the sol to a polytetrafluoroethylene mold, drying to remove the solvent, then transferring the dried sol to a vacuum oven, vacuum drying the dried sol at 120 °C for 24 h to obtain the final solid state electrolyte PEO-LGPS.

### Assembly and testing of button batteries

Preparation of positive electrode plate: dissolving a positive electrode material LiMn₂O₄, acetylene black and the solid state electrolyte prepared in Examples 1 to 4 of the present invention at a weight ratio of 80:10:10 in the solvent of anhydrous acetonitrile to obtain a positive electrode slurry, coating the positive electrode slurry on a current collector of aluminum foil, baking the aluminum foil at 80 °C for 12 h, and obtaining the positive electrode plate having a diameter of 15 mm by punching machine.

The assembly of the button battery: a positive electrode shell, a positive electrode plate/a solid state electrolyte, a lithium plate, an elastic plate and a negative electrode shell are assembled under an argon atmosphere in order into a button battery via pressing seal and forming of a sealing machine, to obtain the battery samples corresponding to Examples 1 to 4 of the present invention, which are denoted as Sample 1 battery, Sample 2 battery, Sample 3 battery and Sample 4 battery, respectively.

The performances of the Sample 1 battery, the Sample 2 battery, the Sample 3 battery, and the Sample 4 battery are tested. The test temperature is 25 °C and 80 °C; the test voltage range is 3.0∼4.3 V, and the charge and discharge rate is 0.1 C.

Table 1 is a comparison of the ionic conductivity of Sample 1 battery, Sample 2 battery, Sample 3 battery, Sample 4 battery at 25 °C and 80 °C.

**Table 1**

| Sample/Conductivity | Ionic conductivity at 25 °C | Ionic conductivity at 80 °C |
|---|---|---|
| Sample 1 | 2.36 × 10⁻⁵ s/cm | 2.57 × 10⁻³ s/cm |
| Sample 2 | 7.51 × 10⁻⁶ s/cm | 5.68 × 10⁻⁴ s/cm |
| Sample 3 | 1.05 × 10⁻⁶ s/cm | 1.69 × 10⁻⁴ s/cm |
| Sample 4 | 6.73 × 10⁻⁷ s/cm | 7.15 × 10⁻⁵ s/cm |

It is clearly shown in Table 1 that, whether the temperature is 25 °C or 80 °C, the Sample 1 battery (PEO-PST-LABGPS) has the highest ionic conductivity, indicating that in the Example 1 of the present invention, the ionic conductivity of the electrolyte material is greatly improved by copolymerization modification of PEO, composite doping of the LGPS, and the combination of both, the performance of the solid state electrolyte is improved, and the charge and discharge stability and the cycle performance of the all solid state battery are improved.

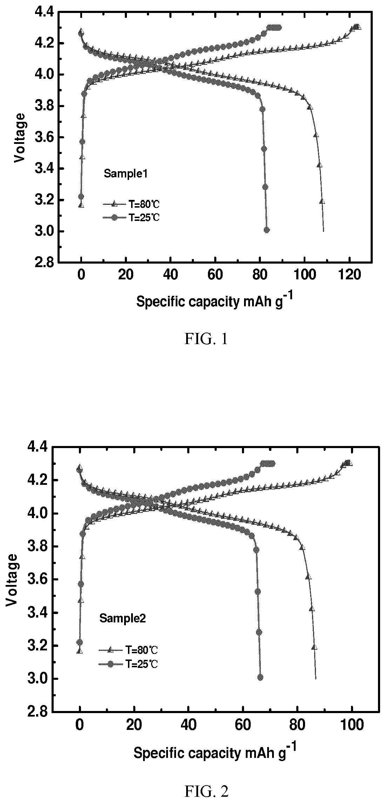

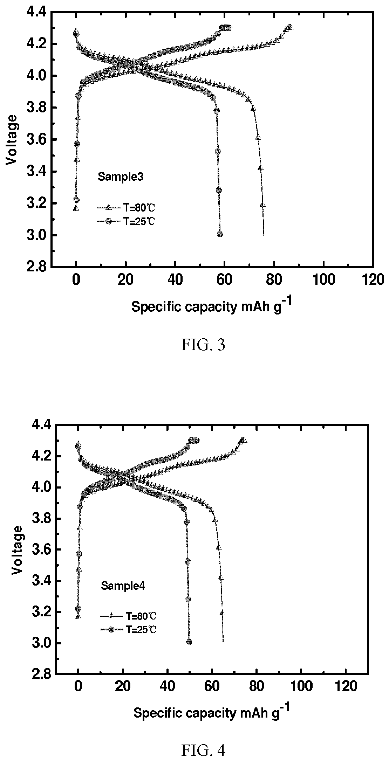

FIG. 1 depicts charging and discharging curves of a Sample 1 battery according to Example 1 of the present invention at different temperatures; FIG. 2 depicts charging and discharging curves of a Sample 2 battery according to Example 2 of the present invention at different temperatures; FIG. 3 depicts charging and discharging curves of a Sample 3 battery according to Example 3 of the present invention at different temperatures; FIG. 4 depicts charging and discharging curves of a Sample 4 battery according to Example 4 of the present invention at different temperatures. As shown in FIGS. 1 to 4, the Sample 1 battery, the Sample 2 battery, the Sample 3 battery and the Sample 4 battery have similar charging and discharging platforms, but the Sample 1 battery has the highest charge discharge specific capacity, exhibiting the best electrochemical performance, because the solid state electrolyte material in the Sample 1 battery (i.e., the solid state electrolyte material prepared in Example 1 of the present invention) has a good ionic conductivity.

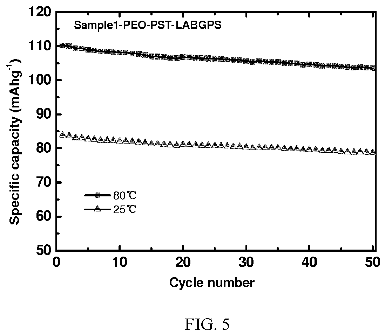

FIG. 5 depicts cycle curves of the Sample1 battery according to Example 1 of the present invention at different temperatures. As shown in FIG. 5, at 25 °C and 80 °C, the Sample 1 battery shows good cycle stability, the capacity fade trend is relatively gentle, wherein the discharge specific capacity at 80 °C is maintained at about 110 mAh/g, the discharge specific capacity at 25 °C is maintained at about 85 mAh/g, indicating that the solid state electrolyte prepared in Example 1 of the present invention in the all solid state battery exhibits excellent electrochemical stability in the all solid state battery.

The present invention provides a method for preparing a composite solid state electrolyte. Firstly, the PEO-PST two-phase polymer electrolyte is obtained by two-phase copolymerization of PEO and PST, the crystallinity of the PEO is reduced by copolymerization, and the room temperature conductivity of the PEO-based polymer is improved. Secondly, the LABGPS solid state electrolyte material having a high crystallinity, small particle size, more stable structure and higher conductivity is obtained by a combination doping modification of the Li₁₀GeP₂S₁₂ with Al and Ba and via mechanical ball milling and microwave heating, which is convenient for homogeneous composite with the PEO-PST two-phase polymer electrolyte. Finally, the organic-inorganic composite solid state electrolyte material PEO-PST-LABGPS was obtained by the uniform composite of the PEO-PST two-phase polymer electrolyte and LABGPS solid state electrolyte, which not only fully exerts the advantages of good mechanical processing performance of the PEO-based polymer and stable coexistence with lithium metal electrode, but also fully exerts the advantage of the high room temperature conductivity of the LGPS-type organic solid state electrolyte, thereby comprehensively improving the comprehensive electrochemical performances of the all solid state lithium battery.

According to the method for preparing a composite solid state electrolyte of the present invention, the composite solid state electrolyte prepared has the advantages of high ionic conductivity, wide electrochemical window, stable structure to metallic lithium, good mechanical processing property and good interface stability, and the all solid state lithium battery using the composite solid state electrolyte has excellent charge and discharge performance and cycle performance.

It will be apparent to those skilled in the art that various modification and variations can be made in the multicolor illumination device and related method of the present invention without departing from the SPI 16rit or scope of the invention. Thus, it is intended that the present invention cover modifications and variations that come within the scope of the appended claims and their equivalents.

## Claims

1. A method for preparing a composite solid state electrolyte, comprising the steps of:
step 1): dissolving a polyethylene oxide monomer and an additive in an organic solvent, stirring at a certain temperature, and obtaining a polymer after filtering;
step 2): adding Ru(Cp*)Cl(PPh₃)₂ to an organic solvent, dissolving the polymer obtained in step 1) and a polystyrene monomer in the organic solvent, stirring at a certain temperature, and obtaining a PEO-PST two-phase polymer after filtering and drying;
step 3): adding Li₂S, P₂S₅, GeS₂, Al₂S₃, BaS in a ball mill tank in a certain proportion and milling evenly to obtain a ball milled powder, pressing the ball milled powder into a wafer, and obtaining an Al, Ba doped solid state electrolyte material LABGPS by microwave heating the wafer; and
step 4): mixing the PEO-PST two-phase polymer obtained in step 2) and the solid state electrolyte material LABGPS obtained in step 3), adding a lithium salt and obtaining a mixture, dissolving and dispersing the mixture in a mixed solution of tetrahydrofuran and acetone, stirring to form a uniform sol and transferring the sol to a mold, drying the sol to remove the solvent, then transferring the dried sol to a vacuum oven for vacuum drying, and obtaining a final composite solid state electrolyte PEO-PST-LABGPS.

2. The method of claim 1, wherein the additive in step 1) is a mixed solution of PhCOCHCl₂, RuCl₂(PPh₃)₃ and dibutylamine.

3. The method of claim 2, wherein the stirring temperature in step 1) is 70-90 °C, and the stirring time is 2-3 hours.

4. The method of claim 3, wherein the organic solvent in step 1), step 2) is at least one of toluene, xylene, cyclohexylbenzene, 1,2-diphenylethane, ethylbenzene, diethylbenzene, propyl benzene, 1,2,4-trimethylbenzene, butylbenzene, dodecylbenzene, p-methyl cumene, biphenyl and naphthalene.

5. The method of claim 4, wherein in step 2), the stirring temperature is 90-120 °C, and the stirring time is 3-5 hours.

6. The method of claim 1, wherein in step 3), a molar ratio of Ge, P, S in Li₂S, P₂S₅, GeS₂, Al₂S₃ and BaS is Ge:P:S = 1:2:12, and a molar ratio of Li, Al, Ba is Li:Al:Ba = 10-3x-2y:x:y, wherein 0.01≤x≤0.2, 0.05≤y≤0.3.

7. The method of claim 6, wherein in step 3), the microwave heating temperature is 500-600 °C, and the heating time is 3-6 hours.

8. The method of claim 7, wherein a mass content of the mixed PEO-PST two-phase polymer and the solid state electrolyte material LABGPS in step 4) is 30-35% and 65-70% respectively.

9. The method of claim 8, wherein in step 4), the lithium salt is LiClO₄, and a molar ratio of a lithium element in the LiClO₄ to the ethylene oxide monomer in the PEO-PST two-phase polymer is 0.03 to 0.08.

10. The method of claim 9, wherein in step 4), the temperature in the vacuum oven is 110-130 °C, and the vacuum drying time is 20-24 hours.
